# EUROPÄISCHE PATENTSCHRIFT

(11) **EP 1 245 030 B1**
(45) Veröffentlichungstag und Bekanntmachung des Hinweises auf die Patenterteilung: **01.06.2005**
(21) Anmeldenummer: 00979447.0
(22) Anmeldetag: 03.11.2000
(51) Int. Cl.: G11C 7/06, G11C 11/419

(54) **SPEICHEREINRICHTUNG**
MEMORY DEVICE
DISPOSITIF DE MEMOIRE

(30) Priorität: 19.11.1999 DE 19955779
(43) Veröffentlichungstag der Anmeldung: 02.10.2002
(60) Teilanmeldung: 04012399.4
(73) Patentinhaber: Infineon Technologies AG, 81669 München (DE)
(72) Erfinder: PAUL, Steffen, 81476 München (DE); SEIFERT, Martin, 81541 München (DE)
(74) Vertreter: Repkow, Ines, Dr. Dipl.-Ing.
(86) Internationale Anmeldenummer: PCT/DE2000/003873
(87) Internationale Veröffentlichungsnummer: WO 2001/039196

(56) Entgegenhaltungen:
- EP-A- 0 747 903
- US-A- 3 760 194

## Beschreibung

Die vorliegende Erfindung betrifft eine Vorrichtung gemäß dem Oberbegriff Anspruchs 1.

Speichereinrichtungen dieser Art sind insbesondere Halbleiterspeicher wie beispielsweise RAMs, ROMs, EPROMs, EEPROMs, Flash-Speicher etc. Solche Speichereinrichtungen sind seit vielen Jahren in unzähligen Ausführungsformen bekannt, beispielsweise aus der US-A-3 760 194 und der EP-A-0 747 903.

Derartige und andere Speichereinrichtungen sollen nach Möglichkeit immer schneller arbeiten und dabei immer weniger Chipfläche beanspruchen und immer weniger Energie verbrauchen.

Hierfür wurden unter anderem bereits diverse Verbesserungen an dem zur Ermittlung der Speicherzelleninhalte vorgesehenen Leseverstärker vorgenommen.

Diese Verbesserungen bestehen unter anderem darin, daß der Inhalt einer auszulesenden Speicherzelle nicht mehr wie früher basierend auf der Spannung ermittelt wird, die sich beim Auslesen der betreffenden Speicherzelle auf der Bitleitung derselben einstellt, sondern basierend auf der Größe und/oder der Richtung des Stromes, der sich beim Auslesen der auszulesenden Speicherzelle zwischen dieser und dem Leseverstärker einstellt. Eine auf dem Stromfluß basierende Ermittlung des Speicherzelleninhalts läßt sich schneller und mit geringerem Energieverbrauch durchführen als es bei einer auf der Spannung basierenden Ermittlung der Fall ist.

Hierdurch konnten Speicherbausteine entwickelt werden, die kleiner sind, mit weniger Energie auskommen, und schneller arbeiten als es vorher der Fall war.

Allerdings hat sich mittlerweile herausgestellt, daß dies nicht immer und überall der Fall ist. Unter gewissen Umständen lassen sich die vorstehend genannten Vorteile nicht erzielen und/oder arbeiten wie beschrieben ausgebildete Speicherbausteine unzuverlässig oder fehlerhaft.

Der vorliegenden Erfindung liegt daher die Aufgabe zugrunde, die Speichereinrichtung gemäß dem Oberbegriff des Anspruchs 1 derart weiterzubilden, daß diese unter allen Umständen klein realisierbar ist, einen geringen Energiebedarf hat, und zuverlässig und schnell arbeitet.

Diese Aufgabe wird erfindungsgemäß durch die in Anspruch 1 beanspruchten Speichereinrichtung gelöst.

Dadurch kann der Leseverstärker unter allen Umständen hervorragend an die gegebenen Verhältnisse (insbesondere an die Auswahltransistor- und Bitleitungswiderstände) angepaßt werden.

Dies ermöglicht es, daß auch nur kurzzeitig fließende und/oder sehr kleine Ströme zuverlässig erkannt werden können.

Der Wegfall der Notwendigkeit, daß zu erfassende Ströme relativ lange fließen müssen und/oder relativ groß sein müssen, um zuverlässig erfaßt zu werden, ermöglicht die Realisierung von Speichereinrichtungen, die eine besonders geringe Größe aufweisen, einen geringen Energiebedarf haben, und dennoch äußerst zuverlässig und sehr schnell arbeiten.

Vorteilhafte Weiterbildungen der Erfindung sind den Unteransprüchen, der nachfolgenden Beschreibung und den Figuren entnehmbar.

Die Erfindung wird nachfolgend anhand von Ausführungsbeispielen unter Bezugnahme auf die Figuren näher erläutert. Es zeigen
- Figur 1: schematisch den Aufbau und die Verschaltung einer Speicherzelle und eines Leseverstärkers zum Auslesen des Speicherzelleninhaltes, und
- Figuren 2: bis 30 Darstellungen der nachfolgend näher beschriebenen Leseverstärker, und

Die nachfolgend näher beschriebene Speichereinrichtung ist ein SRAM. Die nachfolgend näher beschriebenen Besonderheiten der Speichereinrichtung können jedoch auch bei anderen Speicherbausteinen wie beispielsweise anderen RAMs, ROMs, EPROMs, EEPROMs, Flash-Speicher und dergleichen eingesetzt werden.

Die betrachtete Speichereinrichtung weist eine Vielzahl von Speicherzellen auf, die matrixartig in einer Vielzahl von Zeilen und einer Vielzahl von Spalten angeordnet sind.

Die betrachtete Speichereinrichtung ist in CMOS-Technik aufgebaut. Die nachfolgend näher beschriebenen Besonderheiten der betrachteten Speichereinrichtung sind jedoch - gegebenenfalls nach entsprechender Modifikation - auch bei nach anderen Techniken aufgebauten Speichereinrichtungen anwendbar.

Im betrachteten Beispiel sind pro Speicherzellenspalte zwei Bitleitungen vorhanden und überwachbar; auf den Bitleitungen stellen sich unterschiedliche Ströme und Spannungen ein. Der Leseverstärker, unter Verwendung dessen der Inhalt der auszulesenden Speicherzelle ermittelt wird, überwacht im betrachteten Beispiel beide Bitleitungen. Die nachfolgend näher beschriebenen Besonderheiten der betrachteten Speichereinrichtung sind jedoch - gegebenenfalls nach entsprechender Modifizierung - auch anwendbar, wenn nur eine Bitleitung vorhanden ist oder berücksichtigt wird.

Die jeweils auszulesende(n) oder zu beschreibende(n) Speicherzelle(n) der Speichereinrichtung werden durch eine an den Speicherbaustein angelegte Adresse definiert. Eine Decodiereinrichtung ermittelt aus dieser Adresse, welche Speicherzellen(n) durch diese bezeichnet werden. Nachdem dies geschehen ist, können die betreffenden Speicherzellen ausgelesen werden.

Der Leseverstärker, unter Verwendung dessen der Inhalt einer auszulesenden Speicherzelle ermittelt wird, ist im betrachteten Beispiel dazu ausgelegt, den Inhalt der auszulesenden Speicherzelle basierend auf der Größe und/oder der Richtung des Stromflusses festzulegen, der sich beim Auslesen der betreffenden Speicherzelle zwischen dieser und dem Leseverstärker (auf den der auszulesenden Speicherzelle zugeordneten Bitleitung) einstellt.

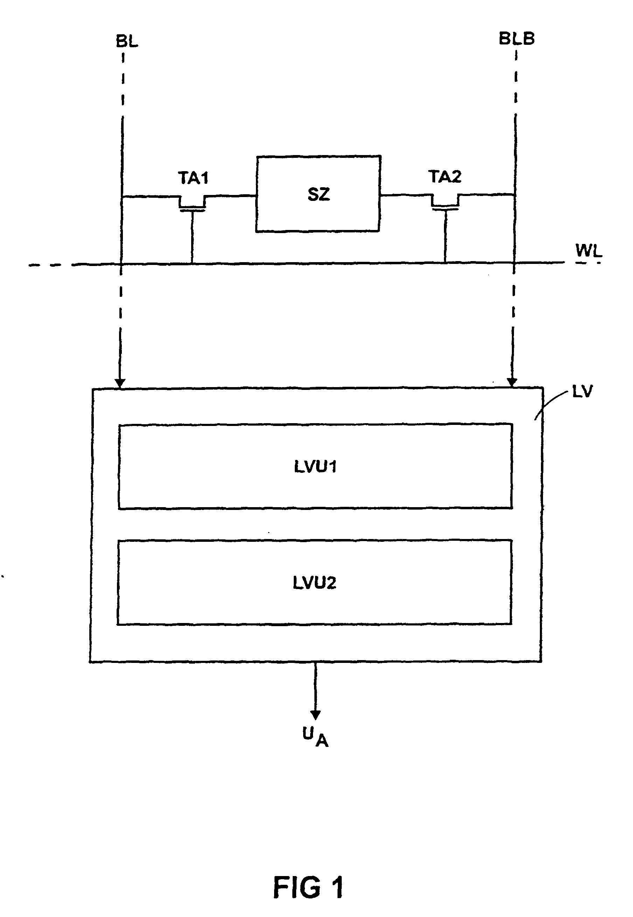

Figur 1 zeigt schematisch den Aufbau und die Verschaltung einer Speicherzelle und eines Leseverstärkers zum Auslesen des Speicherzelleninhalts.

Die Speicherzelle ist dabei mit dem Bezugszeichen SZ bezeichnet, und der Leseverstärker mit dem Bezugszeichen LV.

Die Speicherzelle S2 ist über Auswahltransistoren TA1 und TA2 und Bitleitungen BL und BLB mit dem Leseverstärker LV verbunden.

Die Auswahltransistoren TA1 und TA2 werden über eine zugeordnete Wortleitung WL angesteuert. Die Wortleitung WL ist mit allen Speicherzellen (genauer gesagt den diesen zugeordneten Auswahltransistoren) einer Speicherzellenzeile verbunden und wird von der vorstehend bereits erwähnten, aber in der Figur 1 nicht gezeigten Decodiereinrichtung mit einer Spannung beaufschlagt, durch die die Auswahltransistoren in den leitenden Zustand versetzt werden (wenn aus der betreffenden Speicherzellenzeile ein oder mehrere Speicherzellen ausgelesen werden sollen) oder durch die die Auswahltransistoren in den sperrenden Zustand versetzt werden (wenn aus der betreffenden Speicherzellenzeile keine Speicherzelle ausgelesen werden soll). Die Anordnung enthält ferner eine in der Figur 1 ebenfalls nicht gezeigte Spaltenauswahleinrichtung, durch welche festgelegt wird, von welcher Speicherzellen-Spalte die Bitleitungen BL und BLB durch den Leseverstärker LV überwacht werden sollen (welche Bitleitungen mit dem Leseverstärker verbunden werden).

Der Leseverstärker LV besteht im betrachteten Beispiel aus einer ersten Verstärkerstufe LVU1 und einer zweiten Verstärkerstufe LVU2.

Die erste Verstärkerstufe LVU1 ist ein Eingangsverstärker mit Impedanzwandler. Ihr, genauer gesagt dem Impedanzwandler derselben, obliegt es insbesondere, für einen möglichst geringen Eingangswiderstand des Leseverstärkers zu sorgen (damit die ohnehin schwachen Ströme auf den Bitleitungen ungehindert in den Leseverstärker gelangen können). Dabei kann es sich als vorteilhaft erweisen, wenn der Eingangswiderstand des Leseverstärkers negativ wird, denn dadurch können vorhandene Auswahltransistor- und Bitleitungs-Widerstände eliminiert werden, wodurch der Leseverstärker widerstandslos mit der auszulesenden Speicherzelle verbunden werden kann.

Die zweite Verstärkerstufe LVU2 erfaßt die auf den Bitleitungen BL und BLB fließenden Ströme, legt basierend darauf (vorzugsweise basierend auf der Differenz der Ströme) den Inhalt der betreffenden Speicherzelle fest und gibt ein den Inhalt repräsentierendes Signal U_{A} aus. Es handelt sich im betrachteten Beispiel also um einen Stromdifferenzverstärker mit I/U-Wandler.

Ein möglicher Aufbau eines solchen Leseverstärkers ist aus der US 5.253.137 bekannt. Der aus dieser Druckschrift bekannte Leseverstärker weist allerdings die eingangs erwähnten Nachteile auf.

Der im vorliegend betrachteten Speicherbaustein zum Einsatz kommende Leseverstärker unterscheidet sich hiervon. Er zeichnet sich dadurch aus, daß dessen Eingangswiderstand individuell einstellbar ist.

Wie nachfolgend im einzelnen beschrieben wird, läßt sich dies beispielsweise dadurch erreichen, daß der Leseverstärker eingangsseitig mit
- einem symmetrischen Gatestufenverstärker mit einstellbarer Spannungs-Rückkopplung oder Spannungs-Kreuzkopplung und/oder mit
- einem symmetrischen Gatestufenverstärker, dem eingangsseitig zwei Stromquellen zugeschaltet sind, die unter Verwendung von aus den Gatestüfenverstärker-Zweigen abgegriffenen Spannungen variabel steuerbar sind,
versehen ist.

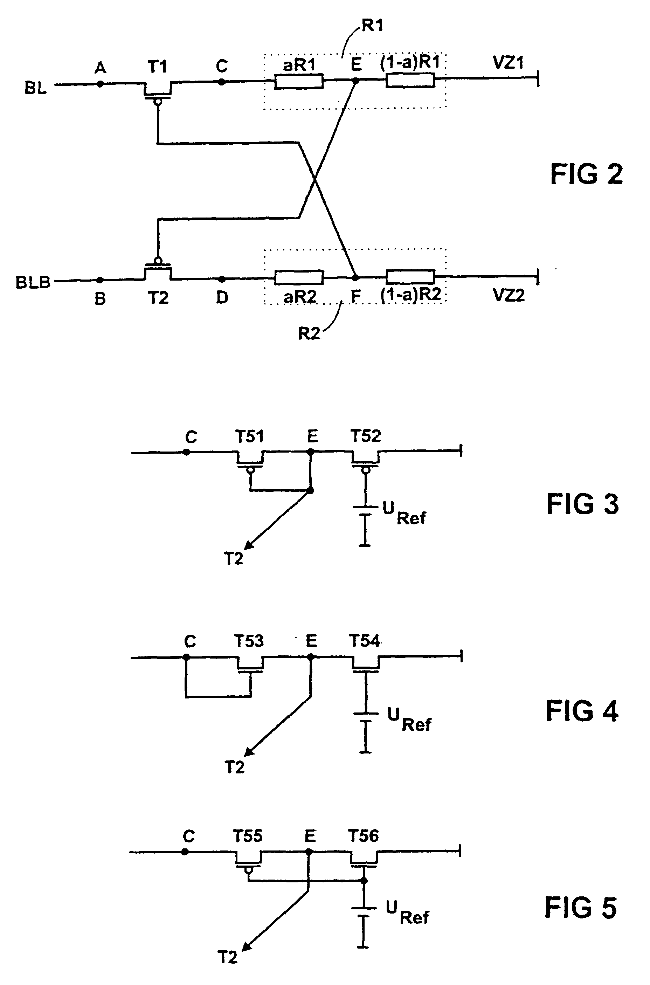

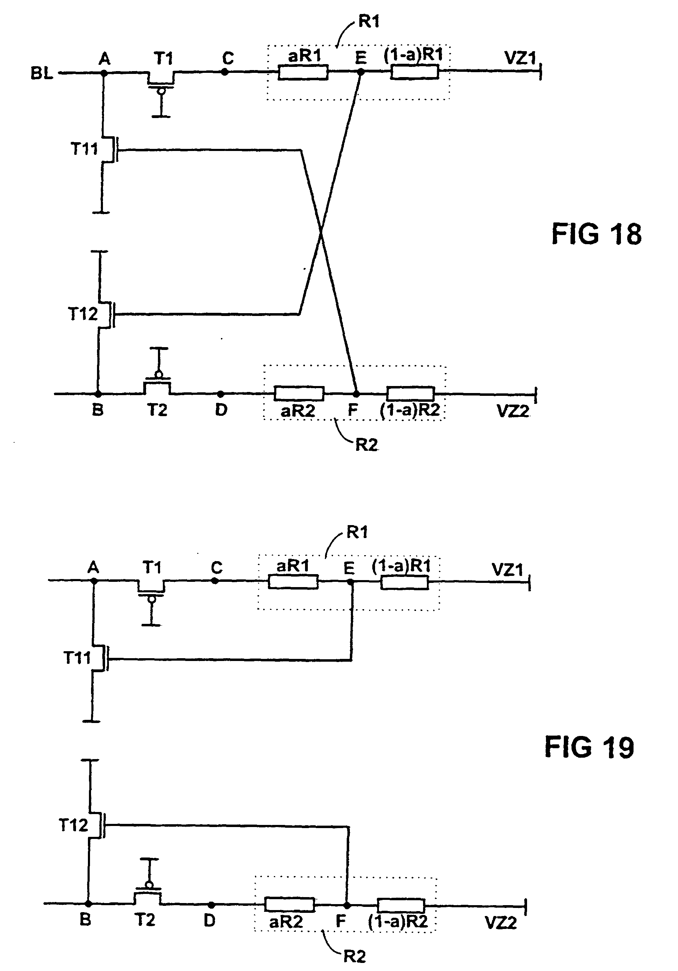

Von den genannten Möglichkeiten wird zunächst unter Bezugnahme auf die Figuren 2 bis 17 die erstgenannte Möglichkeit näher erläutert. Im Anschluß daran wird unter Bezugnahme auf die Figuren 18 bis 24 die zweite Möglichkeit näher erläutert.

Der prinzipielle Aufbau einer Verstärkerstufe, in welcher von der erstgenannten Möglichkeit Gebrauch gemacht wird, ist in Figur 2 dargestellt.

Die Anordnung gemäß Figur 2 ist symmetrisch aufgebaut und besteht aus kreuzgekoppelten (Verstärker-)Zweigen VZ1 und VZ2. Jeder der Zweige enthält einen PMOS-Transistor T1 bzw. T2 und einen dazu in Reihe geschalteten Widerstand R1 bzw. R2. Die zu untersuchenden Bitleitungen BL und BLB sind mit den Sourceanschlüssen der (im betrachteten Beispiel drainseitig über die Widerstände R1 und R2 auf Masse liegenden) Transistoren T1 und T2 verbunden. Die Gateanschlüsse der Transistoren T1 und T2 werden mit einer am Widerstand des jeweils anderen Zweiges abgegriffenen Spannung beaufschlagt. Die an den Widerständen abgegriffenen Spannungen (und damit auch das Ausmaß der Kopplung der Zweige VZ1 und VZ2) sind durch eine Variierung des Abgriffs an den Widerständen R1 und R2 und/oder durch eine Veränderung der Widerstände oder des Widerstandsverhältnisses der die Widerstände R1 und R2 bildenden, diesseits und jenseits des Abgriffpunktes liegenden Teilwiderstände aR und (1-a)R veränderbar. Dadurch läßt sich der Eingangswiderstand der Anordnung gemäß Figur 2 innerhalb gewisser Grenzen beliebig einstellen; er kann dabei sowohl positive als auch negative Werte annehmen.

Die Widerstände R1 und R2 lassen sich beispielsweise
- durch anzapfbare lineare Widerstände (beispielsweise Widerstände in Dünnfilm- oder Poly-Si-Ausführung),
- durch die Reihenschaltung einer PMOS-Diode und einer PMOS-Gatestufe, deren Eingangswiderstand über eine Referenzspannung einstellbar ist und/oder über die Transistordimensionierung eingestellt ist,
- durch die Reihenschaltung einer NMOS-Diode und einer NMOS-Sourcestufe, deren Widerstand über eine Referenzspannung einstellbar ist und/oder über die Transistordimensionierung eingestellt ist, oder
- durch einen CMOS-Spannungsteiler
realisieren.

Die Realisierung der Widerstände R1 und R2 durch die erstgenannte Möglichkeit bedarf keiner näheren Erläuterung.

Die Realisierung der Widerstände R1 und R2 durch die zweitgenannte Möglichkeit eignet sich insbesondere in Fällen, in welchen die Widerstände R1 und R2 hochohmig sind oder sein sollen. Diese Realisierungs-Möglichkeit ist in Figur 3 dargestellt. Dabei werden die PMOS-Diode durch einen entsprechend verschalteten PMOS-Transistor T51, und die PMOS-Gatestufe durch einen entsprechend verschalteten PMOS-Transistor T52 gebildet; die Referenzspannung ist mit U_{Ref} bezeichnet und wird auf den Gateanschluß des Transistors T52 gegeben.

Die Realisierung der Widerstände R1 und R2 durch die drittgenannte Möglichkeit eignet sich insbesondere in Fällen, in welchen die Widerstände R1 und R2 niederohmig sind oder sein sollen. Diese Realisierungs-Möglichkeit ist in Figur 4 dargestellt. Dabei werden die NMOS-Diode durch einen entsprechend verschalteten NMOS-Transistor T53, und die NMOS-Sourcestufe durch einen entsprechend verschalteten NMOS-Transistor T54 gebildet; die Referenzspannung ist wiederum mit U_{Ref} bezeichnet und wird auf den Gateanschluß des Transistors T54 gegeben.

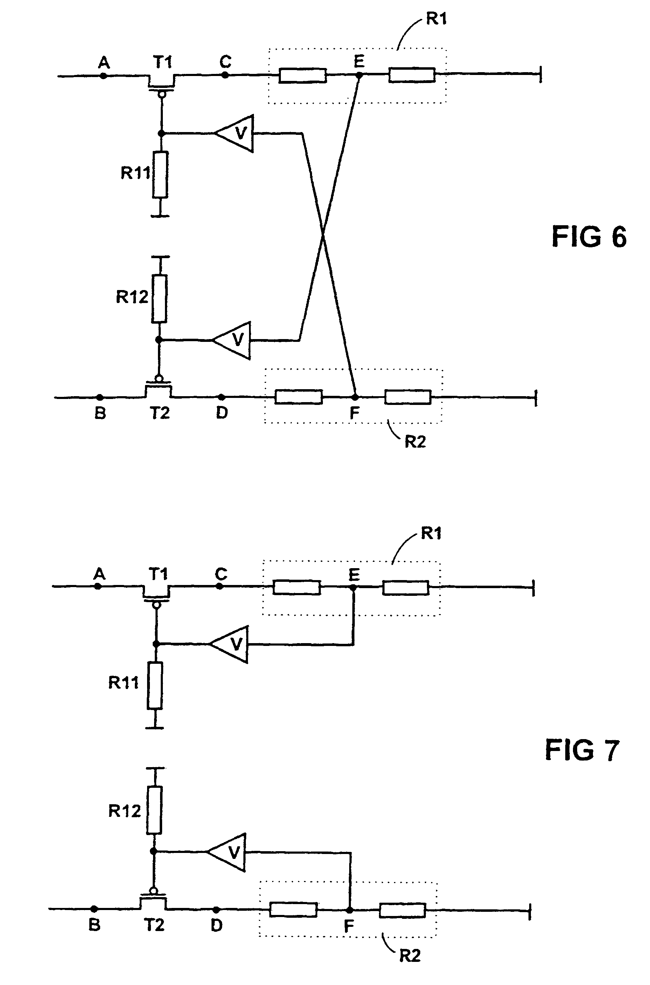

Die Realisierung der Widerstände R1 und R2 durch die letztgenannte Möglichkeit ist in Figur 5 dargestellt. Sie besteht im betrachteten Beispiel aus einer Reihenschaltung eines PMOS-Transistors T55 und eines NMOS-Transistors T56, deren Gateanschlüsse mit einer Referenzspannung U_{Ref} beaufschlagt sind.

Bei den in den Figuren 3 bis 5 gezeigten Realisierungsmöglichkeiten für die Widerstände R1 und R2 in Figur 2 erfolgt der Abgriff der auf die Gateanschlüsse der Transistoren T1 und T2 gegebenen Spannung zwischen den Transistoren T51 und T52 (Figur 3), bzw. zwischen den Transistoren T53 und T54 (Figur 4) bzw. zwischen den Transistoren T55 und T56 (Figur 5). Diese Spannung ist, wie vorstehend bereits erwähnt wurde, durch eine entsprechende Dimensionierung der Transistoren eingestellt und/oder durch eine Variierung der Referenzspannung U_{Ref}, also dynamisch variierbar.

Die dynamische Variierung der auf die Gateanschlüsse der Transistoren T1 und T2 gegebenen Spannung (die Variierung dieser Spannung durch eine Variierung der Referenzspannung) erweist sich als vorteilhaft, weil der Leseverstärker dadurch jederzeit optimal an die im Speicherbaustein herrschenden Verhältnisse angepaßt werden kann. Damit kann sichergestellt werden, daß der Eingangswiderstand des Leseverstärkers unter allen Umständen einen gewünschten Wert aufweist und/oder einen bestimmten Wert nicht unterschreitet oder überschreitet.

Die Einstellung der auf die Gateanschlüsse der Transistoren T1 und T2 gegebenen Spannung durch eine entsprechende Dimensionierung der Transistoren erweist sich als vorteilhaft, weil dadurch ohne Veränderung des prinzipiellen Aufbaus der Schaltung, also auf sehr einfache Weise, Leseverstärker mit beliebigen Eingangswiderständen hergestellt werden.können.

Insbesondere wenn die Variierung des Eingangswiderstandes des Leseverstärkers durch eine Variierung der Referenzspannung U_{Ref} erfolgt, kann mit der Variierung des Eingangswiderstandes des Leseverstärkers auch eine Veränderung der Widerstände R1 und R2 einhergehen.

Dies läßt sich vermeiden, wenn in der Anordnung gemäß Figur 2 in die Rückkopplungszweige, über welche den Gateanschlüssen der Transistoren T1 und T2 die an den Widerständen R1 bzw. R2 abgegriffenen Spannungen zugeführt werden, Trennspannungsverstärker V eingefügt werden. Bei den Trennspannungsverstärkern V kann es sich um nichtinvertierende Verstärker (Verstärkungsfaktor A > 0) oder um invertierende Verstärker (Verstärkungsfaktor A < 0) handeln.

Der Aufbau einer mit nichtinvertierenden Verstärkern V versehenen Anordnung gemäß Figur 2 ist in Figur 6 gezeigt, und der Aufbau einer mit invertierenden Verstärkern V versehenen Anordnung gemäß Figur 2 ist in Figur 7 gezeigt.

Im letztgenannten Fall wird aus der Kreuzkopplung der Zweige VZ1 und VZ2 eine "normale" Rückkopplung.

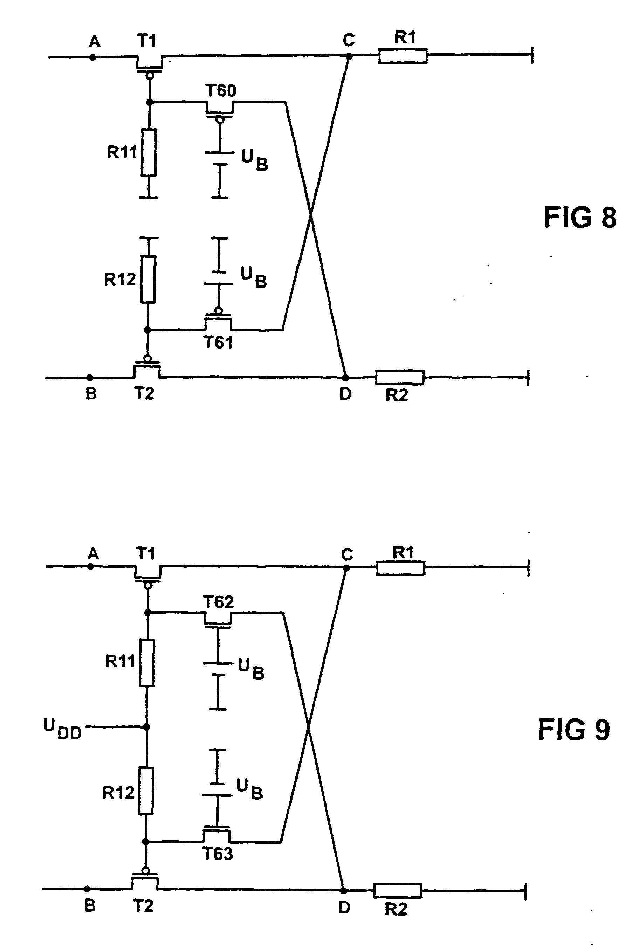

Der Einsatz der Verstärker V ermöglicht es, die über diese auf die Gateanschlüsse der Transistoren T1 und T2 zu gebende Spannung vor den Widerständen R1 und R2 abzugreifen (siehe Figur 8 ff.).

Die nichtinvertierenden Verstärker V in den Kreuz- bzw. Rückkopplungszweigen können jeweils durch eine Gatestufe realisiert werden. Die jeweiligen Gatestufen können dabei auf verschiedenerlei Art und Weise aufgebaut werden.

Wie aus der Figur 8 ersichtlich ist, können die die Verstärker bildenden Gatestufen beispielsweise unter Verwendung von PMOS-Transistoren T60 bzw. T61 realisiert werden (Sourceanschluß mit den Zweigen VZ1 bzw. VZ2 verbunden, Gateanschluß mit einer zur Arbeitspunkteinstellung dienenden Spannung U_{B} beaufschlagt, Drainanschluß mit dem Gateanschluß des Transistors T1 bzw. T2 verbunden sowie über Widerstände R11 und R12 mit Masse verbunden).

Wie aus der Figur 9 ersichtlich ist, können die die Verstärker bildenden Gatestufen auch unter Verwendung von NMOS-Transistoren T62 und T63 realisiert werden (Sourceanschluß mit den Zweigen VZ1 bzw. VZ2 verbunden, Gateanschluß mit einer zur Arbeitspunkteinstellung dienenden Spannung U_{B} beaufschlagt, Drainanschluß mit dem Gateanschluß des Transistors T1 bzw. T2 verbunden sowie über Widerstände R11 und R12 mit der Versorgungsspannung U_{DD} verbunden).

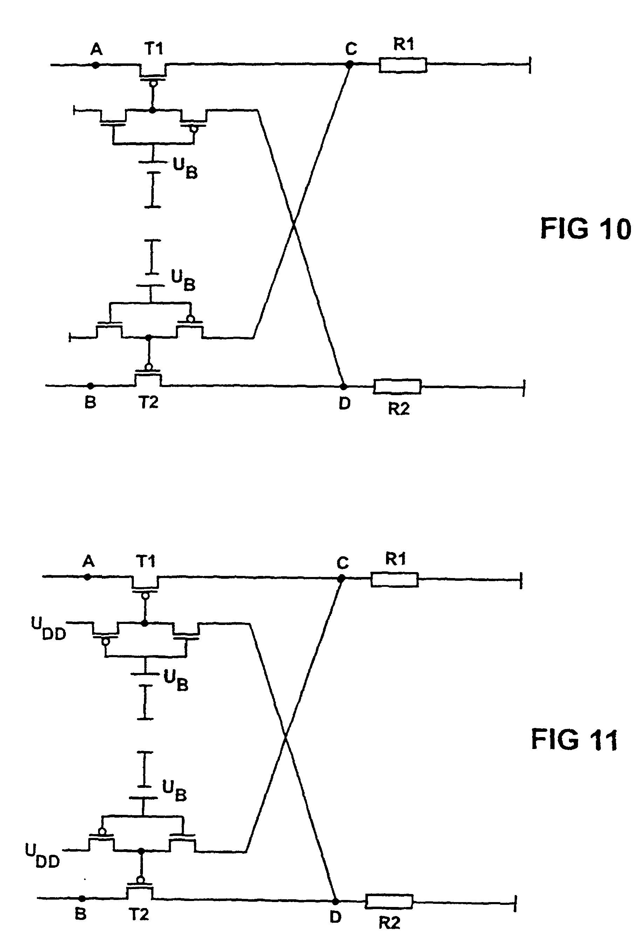

Die die Verstärker bildenden Gatestufen können auch in CMOS-Technik aufgebaut werden. Dies ist in den Figuren 10 und 11 veranschaulicht, wobei die in der Figur 10 gezeigte Anordnung der in der Figur 8 gezeigten Anordnung entspricht, und wobei die in der Figur 11 gezeigte Anordnung der in der Figur 9 gezeigten Anordnung entspricht.

Beim Einsatz von Verstärkern in den Kreuzkopplungszweigen gemäß Figur 6 hat eine Veränderung der Verstärkung der Verstärker V über den Eingangswiderstand des Leseverstärkers auch Einfluß auf die Widerstände R1 und R2. Dieser Einfluß auf die Widerstände R1 und R2 ist aber erheblich schwächer als bei Leseverstärkern nach Art der Figur 2.

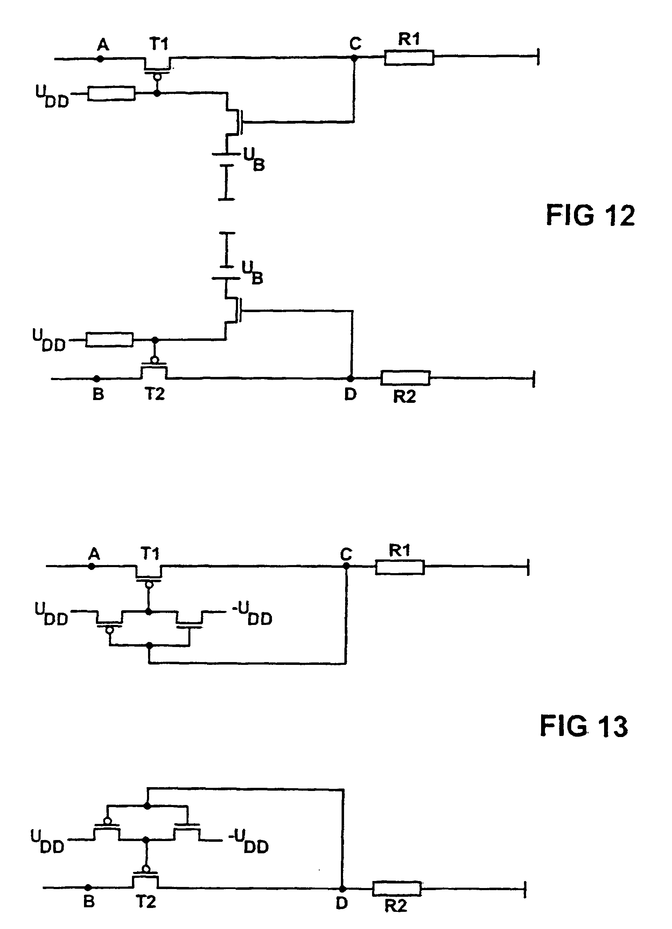

Dieser Einfluß entfällt völlig, wenn die Anordnung nach Figur 7 verwendet wird, weil die darin enthaltenen Verstärker V - insbesondere wenn sie durch eine Sourcestufe (siehe Figur 12) oder durch einen CMOS-Inverter (siehe Figur 13) gebildet werden - rückwirkungsfrei an den Widerständen R1 bzw. R2 bzw. an Abgriffen derselben liegen.

Dies erlaubt die Verwendung hochohmiger Widerstände R1 bzw. R2, wodurch die Transistoren T1 und T2 besonders hohe Spannungsverstärkungen aufweisen können.

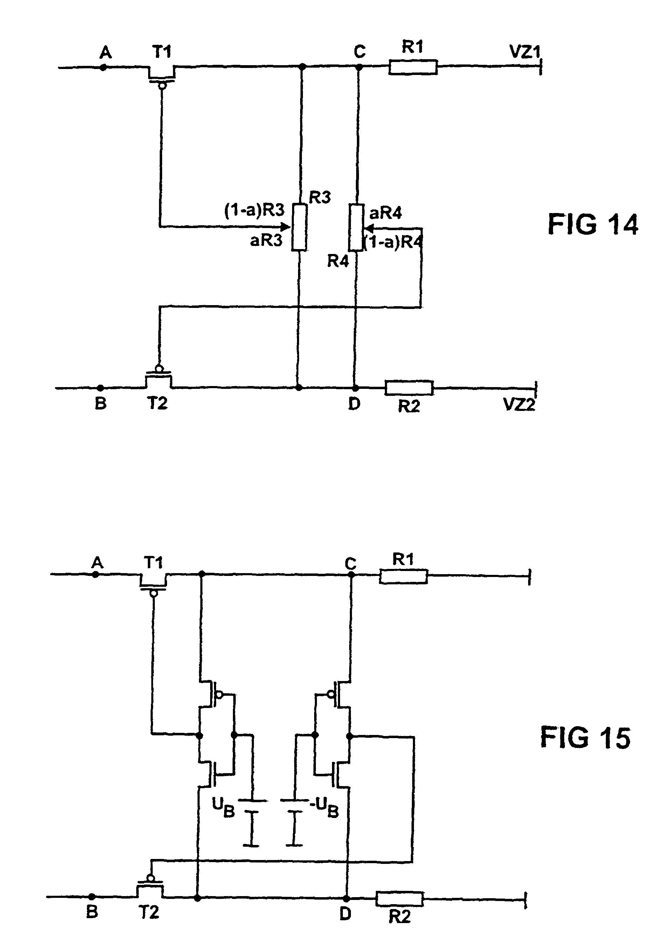

Eine weitere Möglichkeit für einstellbare Spannungsrückund/oder Kreuzkopplungen ist in Figur 14 veranschaulicht. Bei dieser Anordnung wird die an die Gateanschlüsse der Transistoren T1 und T2 angelegte Spannung an zwischen den Zweigen VZ1 und VZ2 (hier: zwischen den Drainanschlüssen der Transistoren T1 und T2) vorgesehenen Widerständen R3 und R4 (R3=R4), genauer gesagt an gegenläufigen Abgriffen derselben abgegriffen.

Der gegenläufige Doppelspannungsteiler gemäß Figur 14 läßt sich beispielsweise durch Reihenschaltung von drei (z.B. durch MOS-Transistoren gebildeten) Widerständen mit zwei dazwischen liegenden Abgriffspunkten bilden.

Eine andere Möglichkeit zur Realisierung des gegenläufigen Doppelspannungsteilers gemäß Figur 14 besteht im Vorsehen eines doppelten CMOS-Spannungsteilers mit verstellbarer gegenpoliger Gatehilfsvorspannung. Eine solche Anordnung ist in Figur 15 dargestellt.

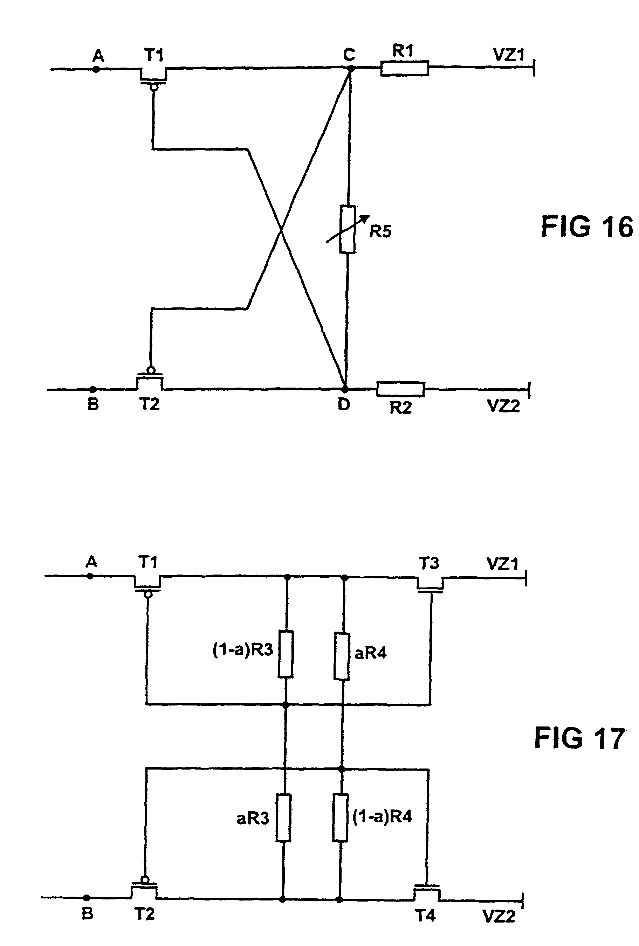

Für den Fall, daß der Parameter a in der Anordnung nach Figur 14 den Wert 1 annimmt, läßt sich die Anordnung gemäß Figur 14 durch die Anordnung gemäß Figur 16 realisieren. Der in dieser Anordnung anstelle der Widerstände R3 und R4 vorgesehene Widerstand R5 kann beispielsweise als spannungsgesteuerter MOS-Widerstand realisiert werden.

Eine besonders einfache Anordnung ergibt sich, wenn die in den Zweigen VZ1 und VZ2 vorgesehenen Widerstände R1 und R2 durch NMOS-Transistoren T3 bzw. T4 realisiert werden, deren Gateanschlüsse mit den Gateanschlüssen der Transistoren T1 und T2 verbunden sind. Dies ist beispielhaft in der Figur 17 dargestellt; die darin gezeigte Anordnung resultiert aus einer wie erwähnt erfolgten Modifikation der in der Figur 14 gezeigten Anordnung.

Die vorstehenden, unter Bezugnahme auf die Figuren 2 bis 17 erfolgten Erläuterungen bezogen sich auf einen Leseverstärker, bei welchem die Einstellbarkeit des Eingangswiderstandes desselben dadurch erreicht wird, daß eingangsseitig ein symmetrischer Gatestufenverstärker mit einstellbarer Spannungs-Rückkopplung oder Spannungs-Kreuzkopplung vorgesehen wird.

Wie eingangs bereits erwähnt wurde, läßt sich eine Einstellbarkeit des Eingangswiderstandes des Leseverstärkers auch dadurch realisieren, daß der Leseverstärker eingangsseitig mit einem symmetrischen Gatestufenverstärker versehen ist, dem eingangsseitig zwei Stromquellen zugeschaltet sind, die unter Verwendung von aus den Verstärker-Zweigen VZ1 und VZ2 abgegriffenen Spannungen variabel steuerbar sind.

Diese zweite Möglichkeit wird nachfolgend unter Bezugnahme auf die Figuren 18 bis 24 näher erläutert.

Der symmetrische Gatestufenverstärker besteht wiederum aus zwei Verstärker-Zweigen VZ1 und VZ2, von welchen jeder einen PMOS-Transistor T1 bzw. T2 und einen dazu in Reihe geschalteten Widerstand R1 bzw. R2 enthält. Insoweit besteht kein Unterschied zu den Leseverstärkern der zuvor beschriebenen Art. Die Zweige VZ1 und VZ2 sind aber eingangsseitig mit steuerharen Stromquellen verbunden. Diese Stromquellen werden im betrachteten Beispiel durch MOS-Transistoren realisiert, die entweder in Sourceschaltung oder in Drainschaltung arbeiten. Durch eine entsprechende Steuerung der Stromquellen kann der Eingangswiderstand der Anordnung innerhalb bestimmter Grenzen frei eingestellt werden.

Eine solche Anordnung ist in Figur 18 dargestellt. Die zu untersuchenden Bitleitungen BL und BLB sind mit den Sourceanschlüssen der (im betrachteten Beispiel gateseitig direkt und drainseitig über die Widerstände R1 und R2 auf Masse liegenden) Transistoren T1 und T2 verbunden. Die Stromquellen, mit denen die Zweige VZ1 und VZ2 eingangsseitig verbunden sind, werden durch in Sourceschaltung arbeitende NMOS-Transistoren T11 und T12 gebildet. Die Sourceanschlüsse dieser Transistoren liegen auf Masse, die Drainschlüsse sind mit den Sourceanschlüssen der Transistoren T1 und T2 verbunden, und die Gateanschlüsse werden mit einer am Widerstand des jeweils anderen Zweiges abgegriffenen Spannung beaufschlagt. Die an den Widerständen abgegriffenen Spannungen und damit auch die durch die Transistoren T11 und T12 fließenden Ströme sind durch eine Variierung des Abgriffs an den Widerständen R1 und R2 und/oder durch eine Veränderung der Widerstände oder des Widerstandsverhältnisses der die Widerstände R1 und R2 bildenden, diesseits und jenseits des Abgriffpunktes liegenden Teilwiderstände aR und (1-a)R veränderbar. Dadurch läßt sich der Eingangswiderstand der Anordnung gemäß Figur 18 innerhalb gewisser Grenzen beliebig einstellen.

Die Gateanschlüsse der Transistoren T11 und T12 können auch mit Spannungen beaufschlagt werden, die am Widerstand des Zweiges abgegriffen werden, mit welchen die Transistoren T11 und T12 verbunden sind. Dies ist in Figur 19 veranschaulicht.

Die Widerstände R1 und R2, an denen sich verschiedene Spannungen abgreifen lassen, können beispielsweise durch Anordnungen gemäß den Figuren 3 bis 5 gebildet werden. Die Spannungen, mit denen die Gateanschlüsse der Transistoren beaufschlagt werden, können auch von zwischen den Zweigen VZ1 und VZ2 angeordneten (Quer-)Spannungsteilern wie beispielsweise bei der Anordnung in Figur 14 abgegriffen werden

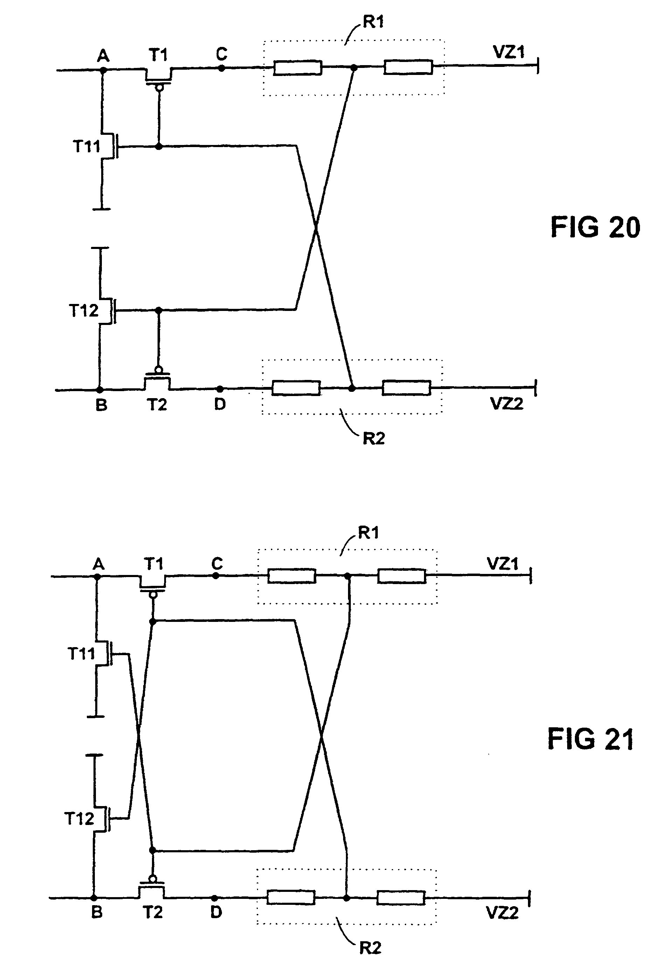

Es ist auch möglich, die Gateanschlüsse der Transistoren T1 und T2 und die Gateanschlüsse der Transistoren T11 und T12 wie in den Figuren 20 und 21 gezeigt zu verbinden. Dabei erweist sich insbesondere die Anordnung gemäß Figur 21 als vorteilhaft, denn durch diese läßt sich der Eingangswiderstand zwischen sehr kleinen positiven Werten und negativen Werten variieren.

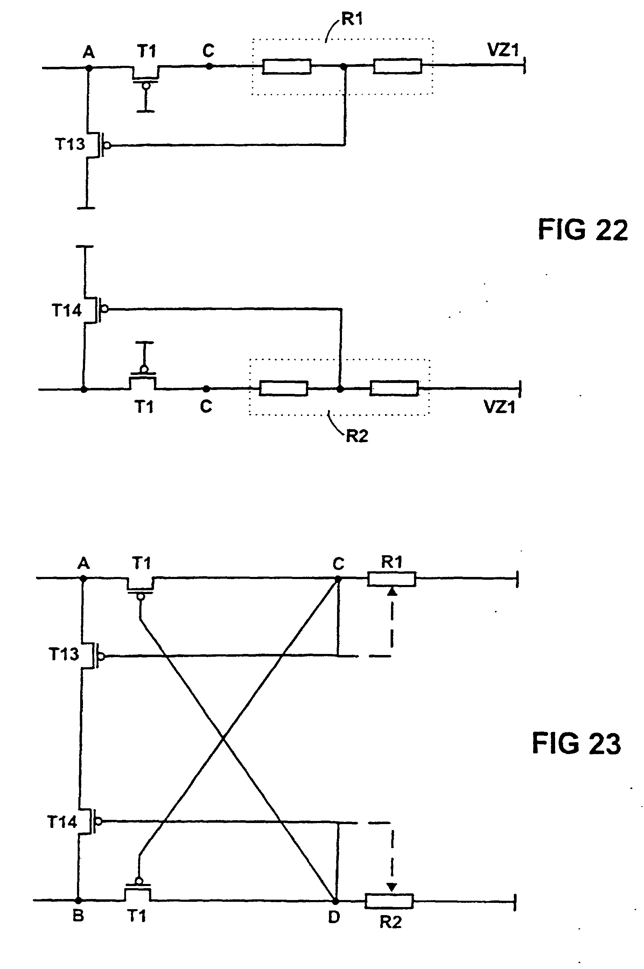

Die durch die Transistoren T11 und T12 gebildeten Stromquellen können, wie vorstehend bereits erwähnt wurde, auch durch in Drainschaltung arbeitende Transistoren realisiert werden. Eine Anordnung, bei welcher dies praktziert wurde, ist in Figur 22 gezeigt. Die die Stromquellen bildenden Transistoren sind die Transistoren T13 und T14. Es handelt sich um PMOS-Transistoren, deren Sourceanschlüsse mit den Zweigen VZ1 und VZ2 verbunden sind, deren Drainanschlüsse auf Masse liegen, und deren Gateanschlüsse mit an den Widerständen R1 und R2 abgegriffenen Spannungen beaufschlagt werden.

Die Spannungen, mit denen die Gateanschlüsse der Transistoren T13 und T14 beaufschlagt werden, werden jeweils an den Widerständen abgegriffen, die in dem Zweig liegen, mit welchem der betreffende Transistor verbunden ist.

Die Anordnung gemäß Figur 22 kann dahingehend modifiziert werden, daß die Gateanschlüsse der Transistoren T1 und T2 nicht auf Masse liegen, sondern mit Spannungen beaufschlagt werden, die vom jeweils anderen Zweig abgegriffen werden. Eine solche Anordnung ist in Figur 23 gezeigt.

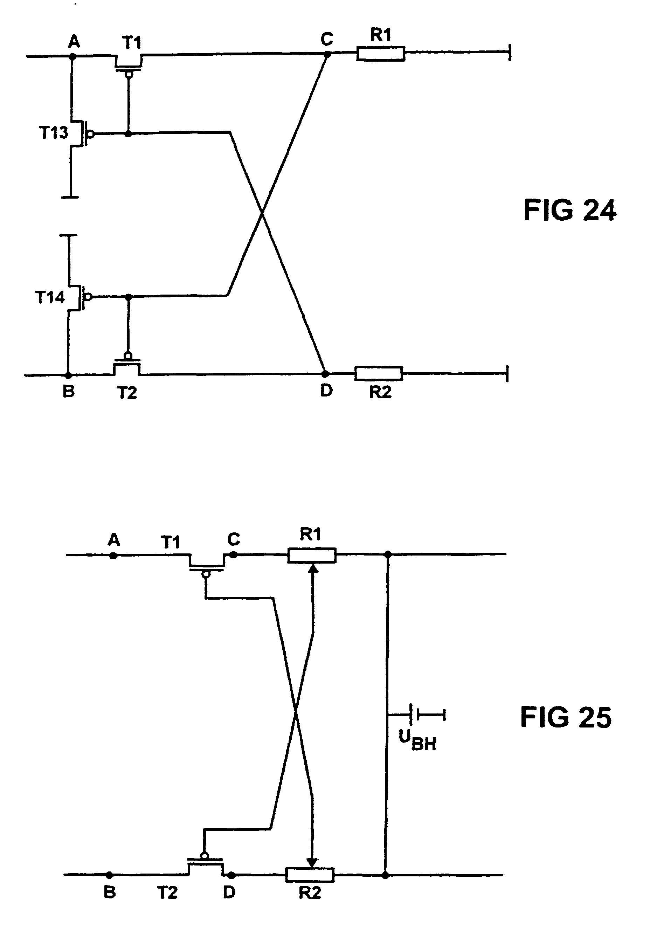

Die Anordnung gemäß Figur 23 kann dahingehend modifiziert werden, daß die Gateanschlüsse der Transistoren T13 und T14 mit den Spannungen beaufschlagt werden, mit denen die Gateanschlüsse der Transistoren T1 und T2 beaufschlagt werden, die sich in dem Zweig befinden, mit dem der betreffende Transistor verbunden ist. Eine solche Anordnung ist in Figur 24 gezeigt.

Die vorstehend unter Bezugnahme auf die Figuren 2 bis 24 beschriebenen Anordnungen lassen sich zumindest teilweise weiter modifizieren.

So ist es beispielsweise möglich, die Zweige VZ1 und VZ2 ausgangsseitig mit einer Hilfsspannung U_{BH} zu beaufschlagen (anstatt sie wie in den Figuren 2 bis 24 dargestellt auf Masse zu legen). Ein Ausführungsbeispiel einer solchen Anordnung ist in Figur 25 dargestellt. Die Spannung U_{BH} kann eine statisch oder dynamisch einstellbare Spannung sein. Durch die Spannung U_{BH} lassen sich die Arbeitspunkte der Zweige VZ1 und VZ2 wunschgemäß verändern.

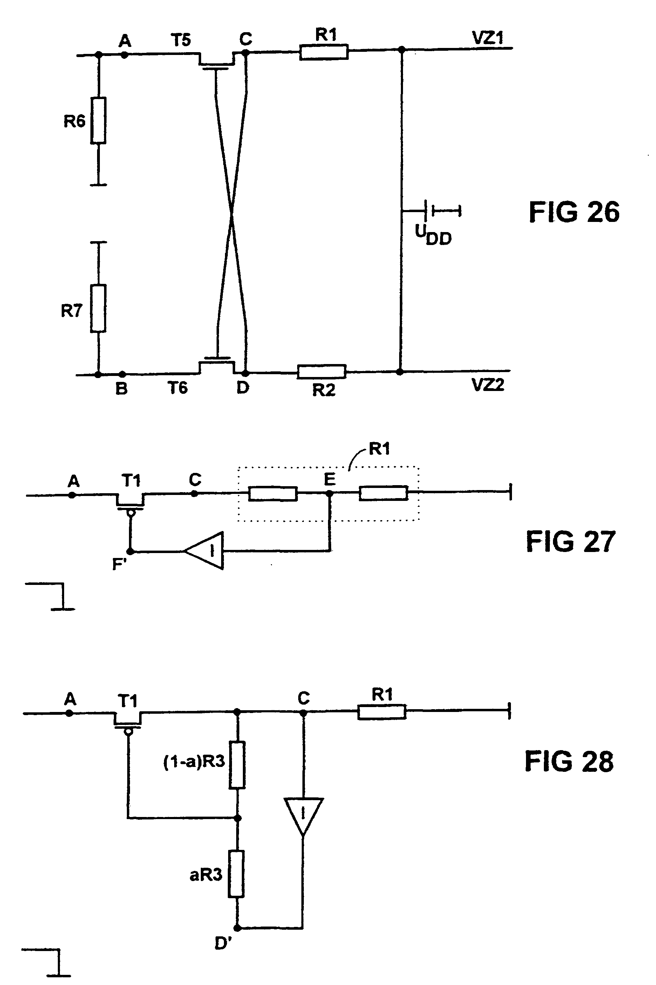

Ferner besteht auch keine Einschränkung darauf, daß die Zweige VZ1 und VZ2 aus einer Reihenschaltung einer p-Kanal-Eingangsgatestufe und eines Widerstandes bestehen. Es kann auch die gefaltete komplementäre Gateeingangsstüfe eingesetzt werden. Dabei arbeiten die Bitleitungen auf Lastelemente bzw. Widerstände R6 und R7 der Bitleitung, welche auch Stromsenken sein können; die die komplementär ausgeführte Gatestufe bildenden NMOS-Transistoren T5 und T6 liegen dann eingangsseitig an den genannten Widerständen, und die Widerstände R1 und R2 an der Versorgungsspannung U_{DD}. Eine Anordnung dieser Art ist in Figur 26 dargestellt; das gezeigte Beispiel ist eine Modifikation der in der Figur 2 gezeigten Anordnung. Die Widerstände R6 und R7 können bei Bedarf wie die Bitleitungs- und Auswahltransistor-Widerstände über einen negativen Eingangswiderstand des Leseverstärkers kompensiert werden. Bei Anordnungen nach Art der Figur 26 lassen sich im übrigen auch die in den Figuren 2 bis 24 dargestellten und unter Bezugnahme darauf beschriebenen Methoden zur Eingangswiderstand-Variierung anwenden. Gegebenenfalls sind zusätzliche und/oder andere Hilfsspannungen bzw. Referenzspannungen für geeignete Arbeitspunkteinstellungen vorzusehen.

Das Prinzip der Variierung des Eingangswiderstandes von positiven Werten bis hin zu negativen Werten durch variable Rückkopplung läßt sich auch bei unsymmetrisch aufgebauten Anordnungen einsetzen. Die bei symmetrischen Anordnungen durch die Schaltungssymmetrie gewonnene Phasenlage der Rückkopplungsspannung muß dann unter Umständen an gespiegelten Netzwerkknoten nachgebildet werden, was beispielsweise unter Verwendung von invertierenden Spannungsfolgern (Invertern) geschehen kann. Die symmetrische Anordnung gemäß Figur 2 läßt sich so unter Verwendung eines Inverters I in die unsymmetrische Anordnung gemäß Figur 27 überführen; die sich am Knoten F' in Figur 27 einstellende Spannung entspricht der sich am Knoten F in Figur 2 einstellenden Spannung.

Auch die symmetrische Anordnung gemäß Figur 14 läßt sich unter Verwendung eines Inverters I in eine unsymmetrische Anordnung überführen. Die entsprechende unsymmetrische Anordnung ist in Figur 28 dargestellt; die sich am Knoten D' in Figur 28 einstellende Spannung entspricht der sich am Knoten D in Figur 14 einstellenden Spannung.

Nach diesem Prinzip lassen sich auch die anderen zuvor beschriebenen Anordnungen in unsymmetrische Anordnungen überführen.

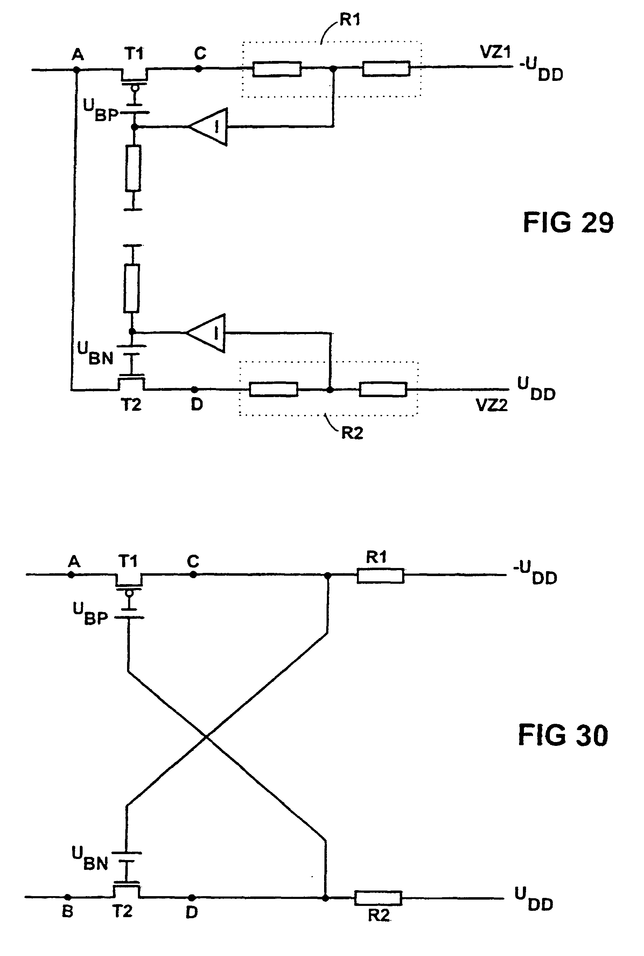

Die Unsymmetrie der Anordnung kann auch darin bestehen, daß die Zweige VZ1 und VZ2 unterschiedlich ausgebildet sind (beispielsweise zueinander komplementäre Transistoren aufweisen). Auch an solchen Anordnungen kann der Eingangswiderstand variiert werden. Zwei Ausführungsbeispiele für mögliche praktische Realisierungen von Anordnungen dieser Art sind in den Figuren 29 und 30 dargestellt.

Der Einsatz von wie beschrieben oder anders aufgebauten unsymmetrischen Leseverstärkern erweist sich insbesondere für die Verarbeitung von bipolaren Signalen als vorteilhaft.

Den vorstehend unter Bezugnahme auf die Figuren 2 bis 30 beschriebenen Anordnungen ist gemeinsam, daß deren Eingangswiderstand auf sehr einfache Weise statisch (durch entsprechende Dimensionierung bestimmter Bauteile) eingestellt ist und/oder dynamisch (durch entsprechende Einstellung oder einen entsprechenden Betrieb bestimmter Bauteile) variierbar bzw. einstellbar ist.

Die Anordnungen unterscheiden sich jedoch insbesondere hinsichtlich der praktischen Realisierbarkeit, der Lage und der Größe des Bereichs, innerhalb dessen der Eingangswiderstand variiert werden kann, der Größe und der Anzahl der Stufen, in denen der Eingangswiderstand verändert werden kann, des Verlaufs der Eingangswiderstand/Stellgrößen-Kennlinie, der Stromverstärkung, und der Rückwirkung auf andere Eigenschaften des Leseverstärkers.

Welche Anordnung für den jeweiligen Einsatz optimal ist, hängt von den jeweiligen Gegebenheiten ab. Die vorstehend beschriebenen und ähnlich aufgebaute Anordnungen eignen sich jedoch ausnahmslos hervorragend für den Einsatz in Leseverstärkern. Sie bilden dabei vorzugsweise die erste von zwei oder mehreren Verstärkerstufen. Durch die zweite und/oder weitere Verstärkerstufen erfolgt eine (weitere) Stromverstärkung und eine Strom/Spannungs-Wandlung. So aufgebaute Leseverstärker sind Stromverstärker mit Strom/Spannungs-Wandlern am Ausgang. Es ist jedoch auch möglich, die von den vorstehend beschriebenen Anordnungen ausgegebenen Ströme sofort, d.h. ohne (weitere) Stromverstärkung einer Strom/Spannungs-Wandlung zu unterziehen, und die dabei erhaltene Spannung zu verstärken. In beiden Fällen liefern die Leseverstärker als Ausgangssignal eine Spannung, deren Höhe den Inhalt der ausgelesenen Speicherzelle repräsentiert.

Wie beschrieben ausgebildete und eingesetzte Leseverstärker ermöglichen es, daß Speichereinrichtungen unter allen Umständen klein realisierbar sind, einen geringen Energiebedarf haben, und zuverlässig und schnell arbeiten.

### Bezugszeichenliste:

- Ax: Adresssignale
- BL: Bitleitung
- BLB: Bitleitung
- I: Inverter
- LV: Leseverstärker
- LVU1: erste Verstärkerstufe
- LVU2: zweite Verstärkerstufe
- POSTDEC: Postdecoder
- PREDEC: Predecoder
- Rx: Widerstände
- SZ: Speicherzelle
- SZZx: Speicherzellen-Zeilen
- Tx: Transistoren
- TAx: Auswahltransistoren
- Ux: Spannungen
- V: Trennspannungsverstärker
- VZx: Verstärkerzweige
- WL: Wortleitung

## Patentansprüche

1. speichereinrichtung mit einer Vielzahl von Speicherzellen (SZ) zum Speichern von Daten; und mit einem Leseverstärker (LV), durch welchen anhand der Größe und/oder der Richtung eines sich beim Auslesen einer Speicherzelle zwischen dieser und dem Leseverstärker einstellenden Stromflusses der Inhalt der betreffenden Speicherzelle ermittelbar ist,
**dadurch gekennzeichnet,**
**daß** der Eingangswiderstand des Leseverstärkers derart variierbar ist, daß er dadurch an den Widerstand der dem Eingangsanschluß des Leseverstärkers vorgeschalteten Komponenten der Speichereinrichtung anpaßbar ist, oder
**daß** der Eingangswiderstand des Leseverstärkers an den Widerstand der dem Eingangsanschluß des Leseverstärkers vorgeschalteten Komponenten der Speichereinrichtung angepaßt ist.

2. Speichereinrichtung nach Anspruch 1,
**dadurch gekennzeichnet,**
**daß** der Leseverstärker (LV) so aufgebaut ist, daß dessen Eingangswiderstand durch eine Variation der Ansteuerung ausgewählter Leseverstärker-Komponenten variierbar ist.

3. Speichereinrichtung nach einem der vorhergehenden Ansprüche,
**dadurch gekennzeichnet,**
**daß** der Leseverstärker (LV) eingangsseitig eine symmetrisch aufgebaute Verstärkerstufe mit zwei identisch ausgebildeten Verstärkerzweigen (VZ1, VZ2) aufweist.

4. Speichereinrichtung nach Anspruch 1 oder 2,
**dadurch gekennzeichnet,**
**daß** der Leseverstärker (LV) eingangsseitig eine unsymmetrisch aufgebaute Verstärkerstufe mit zwei komplementär ausgebildeten Verstärkerzweigen (VZ1, VZ2) aufweist.

5. Speichereinrichtung nach Anspruch 1 oder 2,
**dadurch gekennzeichnet,**
**daß** der Leseverstärker (LV) eingangsseitig eine unsymmetrisch aufgebaute Verstärkerstufe mit nur einem Verstärkerzweig aufweist.

6. Speichereinrichtung nach einem der Ansprüche 3 bis 5,
**dadurch gekennzeichnet,**
**daß** die Verstärkerzweige (VZ1, VZ2) einen in Gateschaltung betriebenen Transistor (T1, T2) und einen diesem nachgeschalteten Lastwiderstand (R1, R2) aufweisen.

7. Speichereinrichtung nach Anspruch 6,
**dadurch gekennzeichnet,**
**daß** der Eingangswiderstand des Leseverstärkers (LV) über die an die Gateanschlüsse der in den Verstärkerzweigen (VZ1, VZ2) vorgesehenen Transistoren (T1, T2) angelegten Spannungen variiert wird.

8. Speichereinrichtung nach Anspruch 6 oder 7,
**dadurch gekennzeichnet,**
**daß** die an die Gateanschlüsse der in den Verstärkerzweigen (VZ1, VZ2) vorgesehenen Transistoren (T1, T2) angelegten Spannungen durch Einstellungen variierbare Spannungen sind.

9. Speichereinrichtung nach Anspruch 6 oder 7,
**dadurch gekennzeichnet,**
**daß** die Gateanschlüsse der in den Verstärkerzweigen (VZ1, VZ2) vorgesehenen Transistoren (T1, T2) über Kopplungszweige mit Spannungen beaufschlagt werden, die an dem den betreffenden Transistor enthaltenden Verstärkerzweig oder am jeweils anderen Verstärkerzweig abgegriffen werden.

10. Speichereinrichtung nach Anspruch 6 oder 7,
**dadurch gekennzeichnet,**
**daß** die Gateanschlüsse der in den Verstärkerzweigen (VZ1, VZ2) vorgesehenen Transistoren (T1, T2) über Kopplungszweige mit Spannungen beaufschlagt werden, die an einem Spannungsteiler abgegriffen werden.

11. Speichereinrichtung nach einem der Ansprüche 6 bis 10,
**dadurch gekennzeichnet,**
**daß** die in den Verstärkerzweigen (VZ1, VZ2) vorgesehenen Lastwiderstände (R1, R2) derart ausgebildet sind, daß an ihnen verschiedene Spannungen abgreifbar sind.

12. Speichereinrichtung nach einem der Ansprüche 6 bis 11,
**dadurch gekennzeichnet,**
**daß** die in den Verstärkerzweigen (VZ1, VZ2) vorgesehenen Lastwiderstände (R1, R2) durch an mehreren Stellen anzapfbare Widerstände gebildet werden.

13. Speichereinrichtung nach einem der Ansprüche 6 bis 11,
**dadurch gekennzeichnet,**
**daß** die in den Verstärkerzweigen (VZ1, VZ2) vorgesehenen Lastwiderstände (R1, R2) durch eine Reihenschaltung eines als Diode geschalteten Transistors (T51; T53) und eines durch einen Transistor (T52; T54) gebildeten Lastwiderstandes realisiert werden.

14. Speichereinrichtung nach Anspruch 10,
**dadurch gekennzeichnet,**
**daß** die in den Verstärkerzweigen (VZ1, VZ2) vorgesehenen Lastwiderstände (R1, R2) durch CMOS-Spannungsteiler (T55, T56) gebildet werden.

15. Speichereinrichtung nach Anspruch 1 oder 2,
**dadurch gekennzeichnet,**
**daß** die Gateanschlüsse der in den Verstärkerzweigen (VZ1, VZ2) vorgesehenen Transistoren (T1, T2) über Kopplungszweige mit Spannungen beaufschlagt werden, die an gegenläufigen Abgriffspunkten von zwischen den Verstärkerzweigen liegenden Spannungsteilern (R3; R4) abgegriffen werden.

16. Speichereinrichtung nach Anspruch 10 oder 15,
**dadurch gekennzeichnet,**
**daß** die Spannungsteiler (R3; R4) durch einen CMOS-Spannungsteiler gebildet wird.

17. Speichereinrichtung nach einem der Ansprüche 6 bis 16,
**dadurch gekennzeichnet,**
**daß** die Kopplungszweige, über welche die in den Verstärkerzweigen (VZ1, VZ2) vorgesehenen Transistoren (T1, T2) gesteuert werden, invertierende oder nicht invertierende Spannungsverstärker (V) enthalten.

18. Speichereinrichtung nach Anspruch 16,
**dadurch gekennzeichnet,**
**daß** die Spannungsverstärker (V) durch einen in Gateschaltung betriebenen Transistor (T60, T61) und einem diesem nachgeschalteten Lastwiderstand (R11, R12) gebildet werden.

19. Speichereinrichtung nach Anspruch 16,
**dadurch gekennzeichnet,**
**daß** die Spannungsverstärker durch einen in Sourceschaltung betriebenen Transistor (T62, T63) und einem diesem nachgeschalteten Lastwiderstand (R11, R12) gebildet werden.

20. Speichereinrichtung nach einem der Ansprüche 6 bis 19,
**dadurch gekennzeichnet,**
**daß** die in den Verstärkerzweigen (VZ1, VZ2) enthaltene Widerstände durch Transistoren (T3, T4) gebildet werden.

21. Speichereinrichtung nach einem der Ansprüche 3 bis 6,
**dadurch gekennzeichnet,**
**daß** die Verstärkerzweige (VZ1, VZ2) eingangsseitig über Transistoren (T11-T14) mit Masse verbunden sind.

22. Speichereinrichtung nach Anspruch 21,
**dadurch gekennzeichnet,**
**daß** die Gateanschlüsse der Transistoren (T11-T14) mit Spannungen beaufschlagt werden, die an den mit den jeweiligen Transistoren verbundenen Verstärkerzweigen (VZ1, VZ2) oder an den jeweils anderen Verstärkerzweigen abgegriffen werden.

23. Speichereinrichtung nach einem der Ansprüche 3 bis 22,
**dadurch gekennzeichnet,**
**daß** den vorhandenen Verstärkerzweigen (VZ1, VZ2) eingangsseitig ein komplementär aufgebauter Verstärkerzweig parallelgeschaltet ist.

## Claims

1. Memory device comprising a multiplicity of memory cells (SZ) for storing data, and comprising a read amplifier (LV), by means of which the content of the relevant memory cell can be determined by means of the magnitude and/or the direction of a current flow occurring during the reading-out of a memory cell between this cell and the read amplifier, **characterized in that** the input impedance of the read amplifier is variable in such a way that it can thereby be matched to the impedance of the components of the memory device which are connected upstream of the input terminal of the read amplifier, or that the input impedance of the read amplifier is matched to the impedance of the components of the memory device which are connected upstream of the input terminal of the read amplifier.

2. Memory device according to Claim 1, **characterized in that** the read amplifier (LV) is constructed in such a manner that its input impedance can be varied by varying the drive to selected read amplifier components.

3. Memory device according to one of the preceding claims, **characterized in that** the read amplifier (LV) has at its input a symmetrically constructed amplifier stage having two identically configured amplifier branches (VZ1, VZ2).

4. Memory device according to Claim 1 or 2, **characterized in that** the read amplifier (LV) has at its input an asymmetrically constructed amplifier stage with two amplifier branches (VZ1, VZ2) of complementary structure.

5. Memory device according to Claim 1 or 2, **characterized in that** the read amplifier (LV) has at its input an asymmetrically constructed amplifier stage having only one amplifier branch.

6. Memory device according to one of Claims 3 to 5, **characterized in that** the amplifier branches (VZ1, VZ2) have a transistor (T1, T2) operated in a common-gate connection and a load resistor (R1, R2) following this transistor.

7. Memory device according to Claim 6, **characterized in that** the input impedance of the read amplifier (LV) is varied via the voltages applied to the gate terminals of the transistors (T1, T2) provided in the amplifier branches (VZ1, VZ2).

8. Memory device according to Claim 6 or 7, **characterized in that** the voltages applied to the gate terminals of the transistors (T1, T2) provided in the amplifier branches (VZ1, VZ2) are voltages which can be varied by adjustments or dimensioning of components.

9. Memory device according to Claim 6 or 7, **characterized in that** voltages which are picked up at the amplifier branch containing the relevant transistor or at the in each case other amplifier branch are applied via coupling branches to the gate terminals of the transistors (T1, T2) provided in the amplifier branches (VZ1, VZ2).

10. Memory device according to Claim 6 or 7, **characterized in that** voltages which are picked up at a voltage divider are applied via coupling branches to the gate terminals of the transistors (T1, T2) provided in the amplifier branches (VZ1, VZ2).

11. Memory device according to one of Claims 6 to 10, **characterized in that** the load resistors (R1, R2) provided in the amplifier branches (VZ1, VZ2) are constructed in such a manner that various voltages can be picked up at them.

12. Memory device according to one of Claims 6 to 11, **characterized in that** the load resistors (R1, R2) provided in the amplifier branches (VZ1, VZ2) are formed by resistors which can be tapped at a number of points.

13. Memory device according to one of Claims 6 to 11, **characterized in that** the load resistors (R1, R2) provided in the amplifier branches (VZ1, VZ2) are implemented by a series-connection of a diode-connected transistor (T51; T53) and of a load resistor formed by a transistor (T52; T54).

14. Memory device according to Claim 10, **characterized in that** the load resistors (R1, R2) provided in the amplifier branches (VZ1, VZ2) are formed by CMOS voltage dividers (T55, T56).

15. Memory device according to Claim 1 or 2, **characterized in that** voltages which are picked up at inversely acting taps of voltage dividers (R3; R4) located between the amplifier branches are applied via coupling branches to the gate terminals of the transistors (T1, T2) provided in the amplifier branches (VZ1, VZ2).

16. Memory device according to Claim 10 or 15, **characterized in that** the voltage divider (R3; R4) is formed by a CMOS voltage divider.

17. Memory device according to one of Claims 6 to 16, **characterized in that** the coupling branches via which the transistors (T1, T2) provided in the amplifier branches (VZ1, VZ2) are controlled contain inverting or non-inverting voltage amplifiers (V).

18. Memory device according to Claim 16, **characterized in that** the voltage amplifiers (V) are formed by a transistor (T60, T61) operated in common-gate connection and by a load resistor (R11, R12) following the former.

19. Memory device according to Claim 16, **characterized in that** the voltage amplifiers are formed by a transistor (T62, T63) operated in common-source connection and by a load resistor (R11, R12) following the former.

20. Memory device according to one of Claims 6 to 19, **characterized in that** the resistors contained in the amplifier branches (VZ1, VZ2) are formed by transistors (T3, T4) .

21. Memory device according to one of Claims 3 to 6, **characterized in that** the inputs of the amplifier branches (VZ1, VZ2) are connected to earth via transistors (T11-T14).

22. Memory device according to Claim 21, **characterized in that** voltages which are picked up at the amplifier branches (VZ1, VZ2) connected to the respective transistors or at the in each case other amplifier branches are applied to the gate terminals of the transistors (T11-T14).

23. Memory device according to one of Claims 3 to 22, **characterized in that** an amplifier branch of complementary construction is connected in parallel with the existing amplifier branches (VZ1, VZ2) at the input end.

## Revendications

1. Dispositif de mémoire doté de plusieurs cellules de mémoire (SZ) qui conservent des données et d'un amplificateur de lecture (LV) par lequel le contenu de la cellule de mémoire concerné peut être déterminé à l'aide de la valeur et/ou de la direction d'un écoulement de courant qui s'établit entre la cellule et l'amplificateur de lecture lors de la lecture de la cellule de mémoire,
**caractérisé en ce que**
la résistance d'entrée de l'amplificateur de lecture peut être modifiée de telle sorte qu'elle peut ainsi être adaptée à la résistance du composant du dispositif de mémoire raccordé en amont de la borne d'entrée de l'amplificateur de lecture ou
**en ce que** la résistance d'entrée de l'amplificateur de lecture est adaptée à la résistance des composants du dispositif de mémoire qui sont raccordés en amont de la borne d'entrée de l'amplificateur de lecture.

2. Dispositif de mémoire selon la revendication 1, **caractérisé en ce que** l'amplificateur de lecture (LV) est construit de telle sorte que sa résistance d'entrée peut être modifiée par une modification de la commande de composants sélectionnés de l'amplificateur de lecture.

3. Dispositif de mémoire selon l'une des revendications précédentes, **caractérisé en ce que** l'entrée de l'amplificateur de lecture (LV) présente un étage d'amplification à structure symétrique avec deux branches d'amplification (VZ1, VZ2) de configuration identique.

4. Dispositif de mémoire selon les revendications 1 ou 2, **caractérisé en ce que** l'entrée de l'amplificateur de lecture (LV) présente un étage d'amplification à structure asymétrique avec deux branches d'amplification (VZ1, VZ2) de configurations complémentaires.

5. Dispositif de mémoire selon les revendications 1 ou 2, **caractérisé en ce que** l'entrée de l'amplificateur de lecture (LV) présente un étage d'amplification à structure asymétrique avec une seule branche d'amplification.

6. Dispositif de mémoire selon l'une des revendications 3 à 5, **caractérisé en ce que** les branches d'amplification (VZ1, VZ2) présentent un transistor (T1, T2) utilisé dans un raccordement par grille et une résistance de charge (R1, R2) raccordée en aval de ce transistor.

7. Dispositif de mémoire selon la revendication 6, **caractérisé en ce que** la résistance d'entrée de l'amplificateur de lecture (LV) est modifiée par les tensions appliquées sur les bornes de grille des transistors (T1, T2) prévus dans les branches d'amplification (VZ1, VZ2).

8. Dispositif de mémoire selon les revendications 6 ou 7, **caractérisé en ce que** les tensions appliquées sur les bornes de grille des transistors (T1, T2) prévus dans les branches d'amplification (VZ1, VZ2) sont des tensions qui peuvent être modifiées par des réglages.

9. Dispositif de mémoire selon les revendications 6 ou 7, **caractérisé en ce que** les bornes de grille des transistors (T1, T2) prévus dans les branches d'amplification (VZ1, VZ2) reçoivent par l'intermédiaire de branches de couplage des tensions qui sont prélevées sur la branche d'amplification qui contient le transistor concerné ou sur l'autre branche d'amplification.

10. Dispositif de mémoire selon les revendications 6 ou 7, **caractérisé en ce que** les bornes de grille des transistors (T1, T2) prévus dans les branches d'amplification (VZ1, VZ2) reçoivent par l'intermédiaire de branches de couplage des tensions qui sont prélevées sur un diviseur de tension.

11. Dispositif de mémoire selon l'une des revendications 6 à 10, **caractérisé en ce que** les résistances de charge (R1, R2) prévues dans les parcours d'amplification (VZ1, VZ2) sont configurées de telle sorte que différentes tensions puissent être prélevées sur elles.

12. Dispositif de mémoire selon l'une des revendications 6 à 11, **caractérisé en ce que** les résistances de charge (R1, R2) prévues dans les branches d'amplification (VZ1, VZ2) sont formées par des résistances aptes à être soutirées en différents emplacements.

13. Dispositif de mémoire selon l'une des revendications 6 à 11, **caractérisé en ce que** les résistances de charge (R1, R2) prévues dans les branches d'amplification (VZ1, VZ2) sont réalisées par le raccordement en série d'un transistor (T51; T53) raccordé comme diode et d'une résistance de charge formée par un transistor (T52; T54).

14. Dispositif de mémoire selon la revendication 10, **caractérisé en ce que** les résistances de charge (R1, R2) prévues dans les branches d'amplification (VZ1, VZ2) sont formées par des diviseurs de tension CMOS (T55, T56).

15. Dispositif de mémoire selon les revendications 1 ou 2, **caractérisé en ce que** les bornes de grille des transistors (T1, T2) prévus dans les branches d'amplification (VZ1, VZ2) reçoivent par l'intermédiaire de branches de couplage des tensions qui sont prélevées sur des points de prélèvement opposés de diviseurs de tension (R3; R4) situés entre les branches d'amplification.

16. Dispositif de mémoire selon les revendications 10 ou 15, **caractérisé en ce que** les diviseurs de tension (R3; R4) sont formés par un diviseur de tension CMOS.

17. Dispositif de mémoire selon l'une des revendications 6 à 16, **caractérisé en ce que** les branches de couplage par lesquelles les transistors (T1, T2) prévus dans les branches d'amplification (VZ1, VZ2) sont commandés contiennent des amplificateurs de tension (V) inversants ou non inversants.

18. Dispositif de mémoire selon la revendication 16, **caractérisé en ce que** les amplificateurs de tension (V) sont formés par un transistor (T60, T61) utilisé dans un raccordement de grille et par une résistance de charge (R11, R12) raccordée en aval de ce transistor.

19. Dispositif de mémoire selon la revendication 16, **caractérisé en ce que** les amplificateurs de tension sont formés par un transistor (T62, T63) utilisé dans un raccordement de source et une résistance de charge (R11, R12) raccordée en aval de ce transistor.

20. Dispositif de mémoire selon l'une des revendications 6 à 19, **caractérisé en ce que** les résistances contenues dans les branches d'amplification (VZ1, VZ2) sont formées par des transistors (T3, T4).

21. Dispositif de mémoire selon l'une des revendications 3 à 6, **caractérisé en ce que** les entrées des branches d'amplification (VZ1, VZ2) sont reliées à la masse par l'intermédiaire de transistors (T11 - T14).

22. Dispositif de mémoire selon la revendication 21, **caractérisé en ce que** les bornes de grille des transistors (T11 - T14) reçoivent des tensions qui sont prélevées sur les branches d'amplification (VZ1, VZ2) liées aux transistors concernés ou sur l'autre branche d'amplification.

23. Dispositif de mémoire selon l'une des revendications 3 à 22, **caractérisé en ce qu'**une branche d'amplification de structure complémentaire est raccordée en parallèle à l'entrée de la branche d'amplification (VZ1, VZ2) présente.
